# EUROPEAN PATENT SPECIFICATION

(11) **EP 3 110 240 B1**
(45) Date of publication and mention of the grant of the patent: **17.04.2019**
(21) Application number: 14882904.7
(22) Date of filing: 21.02.2014
(51) Int. Cl.: H05K 13/02, H05K 13/04, B23P 19/00, B65H 15/00, H01L 21/68

(54) **COMPONENT MOUNTING MACHINE INCLUDING A COMPONENT TRANSFER DEVICE**
KOMPONENTENMONTAGEMASCHINE MIT EINER KOMPONENTENÜBERTRAGUNGSVORRICHTUNG
MACHINE DE MONTAGE DE COMPOSANTS AVEC UN DISPOSITIF DE TRANSFERT DE COMPOSANTS

(43) Date of publication of application: 28.12.2016
(73) Proprietor: FUJI Corporation, Chiryu Aichi (JP)
(72) Inventor: SAITO, Shigeo, Chiryu Aichi (JP)
(74) Representative: Grünecker Patent- und Rechtsanwälte PartG mbB
(86) International application number: PCT/JP2014/054171
(87) International publication number: WO 2015/125273

(56) References cited:
- EP-A2- 1 199 918
- JP-A- S53 116 478
- JP-A- S61 273 418
- JP-A- S61 273 418
- JP-A- 2008 047 644
- JP-A- 2008 047 644
- JP-A- 2008 230 756

## Description

### Technical Field

The present invention relates to a component mounter and component transfer device that transfers a component to a component holding section of a mounting head of a component mounter after rotating the direction (orientation) of a component being supplied 90 or 180 degrees.

### Background Art

Conventional component mounters pick up components supplied from component supply devices (tray feeders, tape feeders, stick feeders, and the like) using a suction nozzle of a mounting head and then mount the components on a circuit board. During the above, components picked up by a suction nozzle are mounted on a circuit board without changing the direction (orientation) of the component, but, depending on the type of component, the direction of the component in a tray purchased commercially from a manufacturer or supplier may be 90 or 180 degrees different from the direction that the component needs to be on the circuit board. In this case, an operator transfers the components from the tray purchased commercially into a dedicated tray changing the component direction by 90 or 180 degrees, and then sets the dedicated tray in the component supply device. Thus, when performing component supply, an operator must perform time-consuming work of transferring components from the tray purchased commercially into a dedicated tray changing the component direction by 90 or 180 degrees, which makes component supply work troublesome.

Therefore, as disclosed in patent literature 1 (JP-A-S62-12521), there are items provided with an orientation flipping device that rotates a component direction by 180 degrees (flipped vertically) during conveyance of components to a component mounter, and that convey the components to the component mounter after components have been rotated 180 degrees by the orientation flipping device.

Similar component mounters are disclosed in JP-2008 047644 A (Patent Literature 2) and JP-S-61 273418 A (Patent Literature 3).

### Citation List

### Patent Literature

Patent Literature 1: JP-A-S62-12521
Patent Literature 2: JP-2008 047644 A
Patent Literature 3: JP-S-61 273418 A

### Summary of Invention

### Technical Problem

However, with the orientation flipping device of patent literature 1, the component direction can only be rotated 180 degrees, it is not possible to rotate a component 90 degrees.

Thus, an object of the present invention is to be able to change the component direction by an angle of 90 degrees and 180 degrees in the event that the component direction differs from the component direction needed for mounting by 90 degrees or 180 degrees.

### Solution to Problem

To solve the above problems, the present invention is a component mounter including a mounting head, a camera, a control device and a component transfer device comprising: a pair of clamp members that face each other in a horizontal direction and that clamp a component by sandwiching the component so as to transfer the component to a component holding section of the mounting head of the component mounter; and a rotation drive source that rotates the clamp members around a center line of the horizontal direction, wherein the component is transferred to the component holding section of the mounting head of the component mounter in a state with the component clamped by the clamping members and rotated 90 degrees or 180 degrees by the clamp members being rotated 90 degrees or 180 degrees by the rotation drive source.

With this configuration, the component clamped by the clamp members is transferred to the component holding section of the mounting head after having been rotated by 90 degrees or 180 degrees by rotating the clamp members of the component transfer device 90 degrees or 180 degrees using the rotation drive source after having clamped the component between the clamp members, thus in cases in which the component direction is different from the component direction for mounting by 90 degrees or 180 degrees, the component direction can be changed by an angle of 90 degrees or 180 degrees as appropriate. Further, for transferring the component, the component holding section of the mounting head may use a surface of the component other than surfaces used by the pair of clamp members.

This component transfer device may be removably set in an empty slot of a feeder set stand of the component mounter, and provided with a connector that connects to a connector of the empty slot used for electric power and communication. With this configuration, it is possible to set the component transfer device on the feeder set stand of the component mounter alongside component supply devices such as tape feeders, and transfer of the component from the component supply device to the component transfer device is able to be performed by the mounting head of the component mounter.

Also, with the present invention, an adjustment means that adjusts the interval between the pair of clamp members may be provided. With this configuration, it is possible to adjust the interval between the clamp members based on the component size using the adjustment means, thus stable clamping operation is achieved regardless of the component size.

In this case, the configuration may be provided with a reference mark section provided on a member that moves together with the clamp members that are moved by the interval adjustment means at a position capable of being imaged by a camera of the component mounter, and a control device of the component mounter may check the interval between the pair of clamp members with reference to the position of the reference mark section by recognizing the reference mark from an image of the reference mark section captured by the camera. With this configuration, after adjusting the interval between the pair of clamp members, it is possible to automatically check whether the interval between the pair of clamp members is suitable for the size of the component to be clamped when clamping the component between the clamp members, thus preventing failure to clamp the component due to inappropriate interval adjustment.

Further, the configuration may be such that the pair of clamp members are biased in the clamp direction by an elastic means and are elastically movable in the unclamp direction (clamp release direction). With this configuration, the impact force imparted on the component when the component is clamped by the clamp members is mitigated by the elastic movement of the clamp members, thus preventing damage to components during clamping.

Further, the component transfer device may be set on the component mounter such that the center line of the horizontal direction of the pair of clamp members is perpendicular to the conveyance direction of the circuit board in the component mounter. With this configuration, the depth dimension of the component transfer device (the dimension in the direction perpendicular to the conveyance direction of the circuit board) can be made long, and the width dimension of the component transfer device (the dimension in the conveyance direction of the circuit board) can be made short, thus making the component transfer device easy to set on the feeder set stand of the component mounter.

Further, a drive source that opens/doses the pair of clamp members may be an air cylinder, and air pressure may be supplied to the air cylinder from the component mounter. With this configuration, the clamp members of the component transfer device can be opened/closed using air pressure used by the component mounter.

Further, multiple component holding sections may be provided on the mounting head of the component mounter such that multiple components can be held, and multiple pairs of clamp members may be provided to correspond to the multiple component holding sections. With this configuration, transfer of components between the component transfer device and the mounting head can be performed with good efficiency.

### Brief Description of Drawings

Fig. 1 is a perspective view showing the configuration of the main sections of the component transfer device of a first embodiment of the present invention.
Fig. 2 is a side view showing the configuration of the main sections of the component transfer device.
Fig. 3 is a perspective view from the top right direction showing the overall component transfer device.
Fig. 4 is a perspective view from the top left direction showing the overall component transfer device.
Fig. 5 is a perspective view showing the component transfer device set on the feeder set stand of a component mounter.

### Description of Embodiments

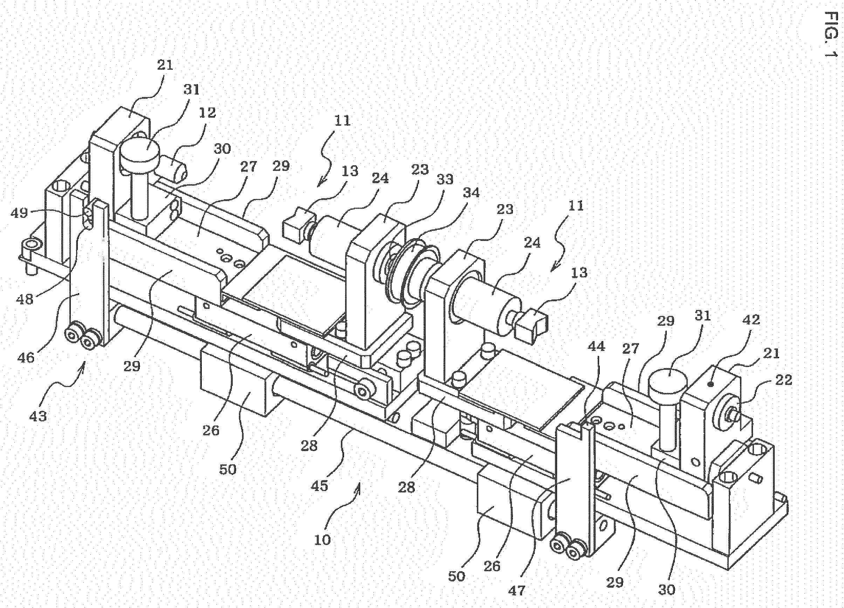

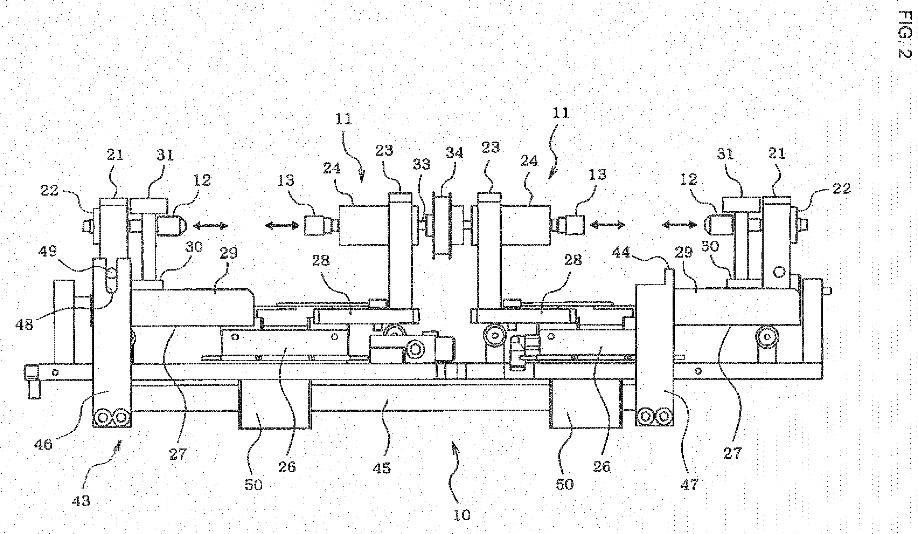

An embodiment of the invention is described below. First, the configuration of component transfer device 10 is described using figs. 1 to 5.

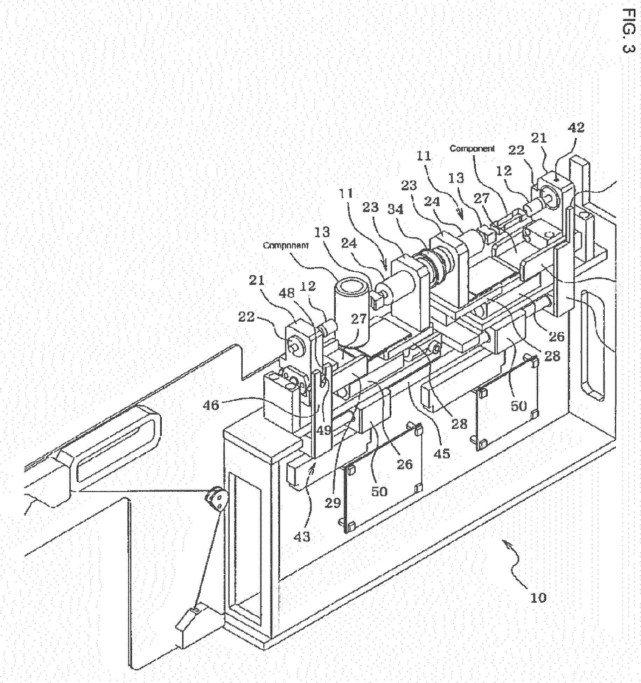

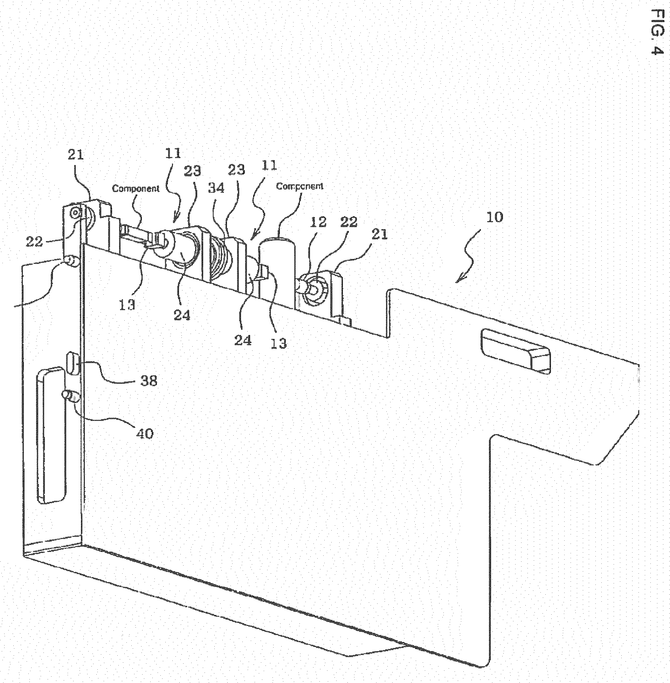

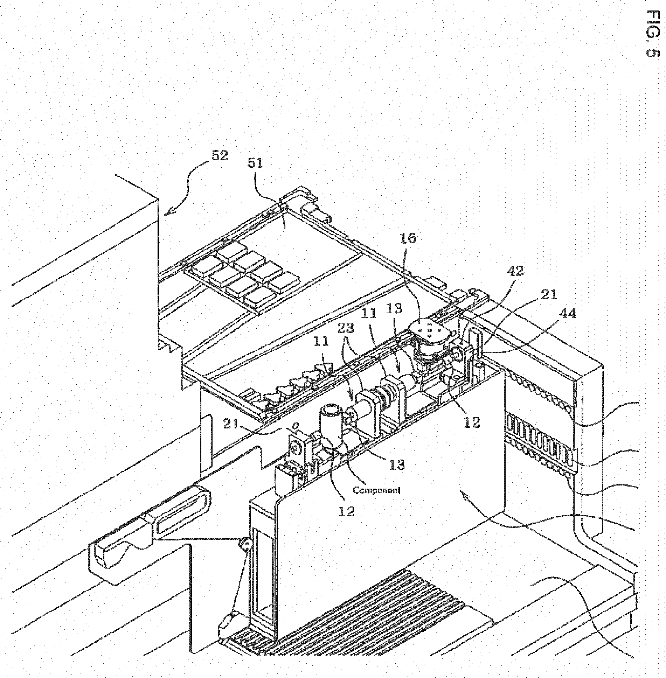

Component transfer device 10 is provided with, for example, two clamp mechanisms 11, and each clamp mechanism 11 is configured to clamp a component by sandwiching the component between a pair of clamp members 12 and 13 that face each other in a horizontal direction (refer to figs. 3 and 4) and transfer the component to component holding section 16 (refer to fig. 5) of a mounting head (not shown) of a component mounter. Note that, component holding section 16 may be a suction nozzle or a chuck, or any item appropriate for the size and shape of the component

In the present invention, two component holding sections 16 are provided on the mounting head of the component mounter to be able to hold two components, and two clamp mechanisms 11 (two pairs of clamps members 12 and 13) are provided on component transfer device 10 to correspond to the two component holding sections 16. Note that, the configuration may be such that three or more clamp mechanisms 11 are provided (three or more pairs of clamp members 12 and 13), or such that only one clamp mechanism 11 (one pair of clamp members 12 and 13) is provided.

One clamp member of each of clamp mechanisms 11, clamp member 12, is supported to be rotatable and slidable in a clamp direction/unclamp direction (horizontal direction) with respect to shaft bearing 22 attached to one of the clamp support members (hereinafter referred to as "interval-adjusting-side clamp support member"), clamp support member 21; the other clamp member, clamp member 13, is attached to be slidable in the clamp direction/unclamp direction and to stop rotation by use of slide-in engagement or the like with respect to tubular rotation connection member 24 rotatably provided on the other clamp support member (hereinafter referred to as "fixed-side clamp support member"), clamp support member 23. Clamp members 12 and 13 of each clamp mechanism 11 are biased on the clamp direction by an elastic means (not shown) such as a spring, and are elastically movable in the unclamp direction against the biasing force of the elastic means.

Clamp support members 21 and 23 of each clamp mechanism 11 are configured to slide (open/close operation) in the clamp direction/unclamp direction by open/close stroke members 27 and 28 of air-chuck-use air cylinder 26, which is a drive source. Fixed-side clamp support member 23 of each clamp mechanism 11 is fixed on open/close stroke member 28; interval-adjusting-side clamp support member 21 is attached to open/close stroke member 27 so as to have a position adjustable in the clamp direction/unclamp direction; the interval between the pair of clamp members 12 and 13 is able to be adjusted by adjusting the position of interval-adjusting-side clamp support member 21 in the clamp direction/unclamp direction based on the size of the component to be clamped.

Guide ribs 29 that guide the movement of interval-adjusting-side clamp support member 21 in the position adjusting direction (clamp direction/unclamp direction) are provided at both edges of interval-adjusting-side open/close stroke member 27 of each clamp mechanism 11; position adjusting screw 31 for fixing interval-adjusting-side clamp support member 21 to open/close stroke member 27 is attached to fixture 30 provided on a lower end of interval-adjusting-side clamp support member 21. When position adjusting screw 31 is loosened, the fixing of interval-adjusting-side clamp support member 21 to open/close stroke member 27 is released, thus allowing the interval between the pair of clamp members 12 and 13 to be adjusted; when position adjusting screw 31 is tightened after the interval has been adjusted, interval-adjusting-side clamp support member 21 is fixed to open/close stroke member 27. In this way, the function of adjusting the interval between the pair of clamp members 12 and 13 corresponds to the "an adjustment means" of the claims.

In the present embodiment, with each clamp mechanism 11, each fixed-side clamp support member 23 is positioned at a center side of component transfer device 10, and the center lines in the horizontal direction of the two pairs of clamp members 12 and 13 are arranged in a straight line. Both ends of the single spline shaft 33 are spline-engaged with tubular rotation connection member 24 rotabably provided on fixed-side clamp support member 23 of the two clamp mechanisms 11. By this, tubular rotation connection members 24 of the two clamp mechanisms 11 are linked to both ends of one spline shaft 33 so as to be rotatable and slidable in the clamp direction/unclamp direction, such that the tubular rotation connection members 24 of the two clamp mechanisms 11 rotate together by the rotation of the single spline shaft, thereby rotating clamp member 13 connected to each tubular rotation connection member 24 by spline-engagement.

Pulley 34 is fixedly engaged to a center section of spline shaft 33, and a belt (not shown) is provided connecting pulley 34 and a drive pulley (not shown) formed from a rotation drive source such as a motor. By rotating clamp member 13 on the pulley 34 side of each clamp mechanism 11 90 degrees or 180 degrees using the rotation drive source, the direction of the component clamped between clamp members 12 and 13 is rotated 90 degrees or 180 degrees together with opposite-side clamp member 12.

Note that, in the present embodiment, the rotation angle of clamp member 13 on the pulley 34 side can be set to any angle, not just 90 degrees or 180 degrees, such that the direction of the component clamped between clamp members 12 and 13 can be rotated by any angle before the component is transferred to component holding section 16 of the mounting head.

Although not shown in the figures, an air pipe and air hose and the like provided on the component mounter are detachably connected to the air inlet section of air cylinder 26 of each clamp mechanism 11, such that air pressure is supplied from the component mounter, with opening/closing of clamp members 12 and 13 of each clamp mechanism 11 being performed using the air pressure used by the component mounter.

Component transfer device 10 is detachably set on an empty slot of feeder set stand 36 (refer to fig. 5) of the component mounter such that the center line in the horizontal direction of clamp members 12 and 13 of each clamp mechanism 11 is perpendicular to the conveyance direction of the circuit board in the component mounter. As shown in figs. 4 and 5, connector 38 that connects to electrical power/communication connector 37 of an empty slot of feeder set stand 36, and positioning pin 40 that is inserted into position hole 39 of the empty slot so as to position component transfer device 10 are provided on an end surface at the setting direction side of component transfer device 10.

Reference mark 42 (refer to fig. 1) is provided on an upper surface of adjusting-side clamp support member 21 of, out of the two clamp mechanisms 11 of component transfer device 10, the clamp mechanism 11 positioned at the setting direction side of component transfer device 10, reference mark section 42 being positioned to be able to be imaged by a camera (not shown) of the component mounter for imaging board marks. The control device (not shown) of the component mounter recognizes reference mark section 42 from an image of reference mark section 42 captured by the camera, and checks the interval between clamp members 12 and 13 of clamp mechanism 11 on which reference mark section 42 is provided by referring to the position of reference mark section 42.

The camera of the component mounter for imaging board marks is able to move above adjusting-side clamp support member 21 of clamp mechanism 11 positioned at the setting direction side of component transfer device 10, but is unable to move above adjusting-side clamp support member 21 of clamp mechanism 11 positioned at the removing direction side of component transfer device 10, therefore, slide mechanism 43 that slides together with adjusting-side clamp support member 21 is provided on the clamp mechanism 11 positioned at the removing direction side, and reference mark section 44 is provided on slide mechanism 43 at a position capable of being imaged by the camera. With slide mechanism 43, two slide plates, slide plates 46 and 47, are fixed facing up to both ends of slide shaft 45, and pin 49 provided on adjusting-side clamp support member 21 engages with engaging groove 48 of slide plate 46, and reference mark section 44 is provided on an upper end of slide plate 47. Slide shaft 45 is supported so as to be slidable in the slide direction of adjusting-side clamp support member 23 by shaft bearing 50 provided on component transfer device 10. The control device of the component mounter recognizes reference mark section 44 from an image of reference mark section 44 captured by the camera, and checks the interval between clamp members 12 and 13 of clamp mechanism 11 integrally provided with which reference mark section 44 by referring to the position of reference mark section 44.

Tape feeders (not shown) are set on feeder set stand 36 of the component mounter in addition to component transfer device 10. Also, as shown in fig. 5, tray feeder 52 that supplies components loaded on tray 51 can be set next to feeder set stand 36 of the component mounter.

During operation (production) of the component mounter, to rotate the direction of a component supplied from tray feeder 52 or a tape feeder or the like by 90 degrees or 180 degrees and then mount the component on a circuit board, the component supplied from tray feeder 52 or a tape feeder or the like is picked up by component holding section 16 of the mounting head of the component mounter, and the component is clamped between clamp members 12 and 13 of each clamp mechanism 11 of component transfer device 10.

Then, by rotating clamp member 13 on the pulley 34 side of each clamp mechanism 11 90 degrees or 180 degrees using the rotation drive source of component transfer device 10, the direction of the component clamped between clamp members 12 and 13 is rotated 90 degrees or 180 degrees together with opposite-side clamp member 12. Next, the component held between clamp members 12 and 13 of each clamp mechanism 11 is picked up by component holding section 16 of the mounting head of the component mounter and mounted on the circuit board.

When adjusting the interval between clamp members 12 and 13 of each clamp mechanism 11 based on the size of the component to be clamped, before production an operator loosens position adjusting screw 31 to release the fixing of interval-adjusting-side clamp support member 21, and then, after adjusting the interval between clamp members 12 and 13 by sliding adjusting-side clamp support member 21 based on the size of the component to be clamped, fixes adjusting-side clamp support member 21 to open/close stroke member 27. After production has started, the control device of the component mounter checks the interval between clamp members 12 and 13 of each clamp mechanism 11 by referring to the position of reference mark sections 42 and 44 recognized from images of reference mark sections 42 and 44 captured by the camera, and then clamps the component held by component holding section 16 of the mounting head between clamp members 12 and 13 of each clamp mechanism 11 of component transfer device 10. Accordingly, after adjusting the interval between clamp members 12 and 13 of each clamp mechanism 11, it is possible to automatically check whether the interval between clamp members 12 and 13 is suitable for the size of the component to be clamped when clamping the component between clamp members 12 and 13, thus preventing failure to clamp the component due to inappropriate interval adjustment.

With present embodiment described above, the component clamped by clamp members 12 and 13 of component transfer device 10 is transferred to component holding section 16 of the mounting head after having been rotated by 90 degrees or 180 degrees by rotating clamp members 12 and 13 90 degrees or 180 degrees using the rotation drive source after having clamped the component between clamp members 12 and 13, thus in cases in which the component direction is different from the component direction for mounting by 90 degrees or 180 degrees, the component direction can be changed by an angle of 90 degrees or 180 degrees as appropriate. Further, for transferring the component, component holding section 16 of the mounting head may use a surface of the component other than surfaces used by pair of clamp members 12 and 13.

Further, with this configuration, because component transfer device 10 is detachably set on an empty slot of feeder set stand 36 of the component mounter, it is possible to set component transfer device 10 on feeder set stand 36 of the component mounter alongside component supply devices such as tape feeders and tray feeder 52, and transfer of the component from the component supply device to component transfer device 10 is able to be performed by the mounting head of the component mounter.

Also, because the interval between clamp members 12 and 13 of each clamp mechanism of component transfer device 10 is adjustable based on the size of the component to be clamped, stable clamping operation is performed regardless of the size of the component.

Further, because clamp members 12 and 13 of each clamp mechanism 11 of component transfer device 10 are biased in the clamp direction by an elastic means and are elastically movable in the unclamp direction, the impact force imparted on the component when the component is clamped by clamp members 12 and 13 is mitigated by the elastic movement of clamp members 12 and 13, thus preventing damage to components during clamping.

Also, because component transfer device 10 is detachably set on an empty slot of feeder set stand 36 of the component mounter such that the center line in the horizontal direction of clamp members 12 and 13 of component transfer device 10 is perpendicular to the conveyance direction of the circuit board in the component mounter, the depth dimension of component transfer device 10 (the dimension in the direction perpendicular to the conveyance direction of the circuit board) can be made long, and the width dimension of component transfer device 10 (the dimension in the conveyance direction of the circuit board) can be made short, thus making component transfer device 10 easy to set on feeder set stand 36 of the component mounter.

Further, because the drive source to open/close clamp members 12 and 13 of component transfer device 10 is air cylinder 26, and air pressure is supplied to air cylinder 26 from the component mounter, clamp members 12 and 13 of component transfer device 10 are opened/closed using air pressure used by the component mounter.

Further, with the present embodiment, multiple component holding sections 16 are provided on the mounting head of the component mounter such that multiple components can be held, and multiple pairs of clamp members 12 and 13 are provided on component transfer device 10 to correspond to the multiple component holding sections 16, therefore transfer of components to and from component transfer device 10 and the mounting head is performed with good efficiency.

Note that, the present invention is not limited to the above embodiments and various changed embodiments that do not depart from the scope of the invention may be applied, for example, the component transfer device may be arranged at a location other than feeder set stand 36.

### Reference Signs List

10: component transfer device; 11: clamp mechanism; 12, 13: clamp member; 16: component holding device; 21: interval-adjusting-side clamp support member; 23: fixed-side clamp support member; 24: tubular rotation connection member; 26: air cylinder (drive source); 27, 28: open/close stroke member; 31: position adjusting screw (interval adjustment means); 33: spline shaft; 34: pulley; 36: feeder set stand; 37: electrical power/communication connector; 38: connector; 39: positioning hole; 40: positioning pin; 42: reference mark section; 43: slide mechanism; 44: reference mark section; 52: tray feeder

## Claims

1. A component mounter including a mounting head, a camera, a control device and a component transfer device (10) with the component transfer device (10) comprising:
a pair of clamp members (12, 13) that face each other in a horizontal direction and that are configured to clamp a component by sandwiching the component so as to transfer the component to a component holding section (16) of the mounting head of the component mounter; and
a rotation drive source that is configured to rotate the clamp members (12, 13) around a center line of the horizontal direction when a component is clamped by the clamp members (12, 13), wherein
the component transfer device (10) is configured to transfer the component to the component holding section (16) of the mounting head of the component mounter in a state with the component clamped by the clamping members (12, 13) and rotated 90 degrees or 180 degrees by the clamp members (12, 13) being rotated 90 degrees or 180 degrees by the rotation drive source,
**characterized by**
a reference mark section (42, 44) provided on a member that is configured to move together with the clamp members (12, 13) that are moved by the interval adjustment means, at a position capable of being imaged by the camera of the component mounter, and wherein
the control device of the component mounter is configured to check the interval between the pair of clamp members (12, 13) with reference to the position of the reference mark section by recognizing the reference mark from an image of the reference mark section (42, 44) captured by the camera.

2. The component mounter according to claim 1, wherein
the component transfer device (10) is removably set in an empty slot of a feeder set stand of the component mounter, and provided with a connector (38) that connects to a connector (37) of the empty slot used for electric power and communication.

3. The component mounter according to claim 1 or claim 2, wherein the component transfer device (10) is further provided with
an interval adjustment means (31) that is configured to adjust the interval between the pair of clamp members (12, 13).

4. The component mounter according to any one of claims 1 to 3, wherein
the pair of clamp (12, 13) members are biased in the clamp direction by an elastic means and are elastically movable in the unclamp direction.

5. The component mounter according to any one of claims 1 to 4, wherein
the component transfer device (10) is configured to be set on the component mounter such that the center line of the horizontal direction of the pair of clamp members (12, 13) is perpendicular to the conveyance direction of the circuit board in the component mounter.

6. The component mounter according to any one of claims 1 to 5, wherein
a drive source that is configured to open/close the pair of clamp members (12, 13) is an air cylinder, and air pressure is supplied to the air cylinder (26) from the component mounter.

7. The component mounter according to any one of claims 1 to 6, wherein
when multiple component holding sections (16) are provided on the mounting head of the component mounter such that multiple components can be held,
multiple pairs of clamp members (12, 13) are provided to correspond to the multiple component holding sections (16).

8. The component mounter of any one of claims 1 to 7, on which is set the component transfer device (10) and a component supply device that is configured to supply components, wherein
a component supplied by the component supply device is picked up by the component holding section (16) of the mounting head and clamped between the pair of clamp members (12, 13) of the component transfer device (10), and then transferred to the component holding section (16) of the mounting head after the direction of the component clamped by the clamp members (12, 13) has been rotated 90 degrees or 180 degrees by the clamp members being rotated 90 degrees or 180 degrees by the rotation drive source.

## Patentansprüche

1. Eine Komponentenbestückungsvorrichtung umfasst einen Montagekopf, eine Kamera, eine Steuervorrichtung und eine Komponententransfervorrichtung (10) mit der Komponententransfervorrichtung (10) umfassend:
ein Paar von Klemmelementen (12, 13), die sich in einer horizontalen Richtung einander zugewandt sind und die konfiguriert sind, eine Komponente durch Einklemmen der Komponente zu klemmen, um die Komponente zu einem Komponentenhalteabschnitt (16) des Montagekopfes der Komponentenbestückungsvorrichtung zu transferieren; und
eine Drehantriebsquelle, die konfiguriert ist, um die Klemmelemente (12, 13) um eine Mittellinie der horizontalen Richtung zu drehen, wenn eine Komponente durch die Klemmelemente (12, 13) geklemmt wird, wobei
die Komponententransfervorrichtung (10) konfiguriert ist, um die Komponente zu dem Komponentenhalteabschnitt (16) des Montagekopfs der Komponentenbestückungsvorrichtung in einem Zustand zu transferieren, bei dem das Bauteil durch die Klemmelemente (12, 13) geklemmt ist und um 90 Grad oder 180 Grad gedreht wird, indem die Klemmelemente (12, 13) durch die Drehantriebsquelle um 90 Grad oder 180 Grad gedreht werden,
**gekennzeichnet durch:**
einen Referenzmarkierungsabschnitt (42, 44), der an einem Element vorgesehen ist, das konfiguriert ist, um sich zusammen mit den Klemmelementen (12, 13) zu bewegen, die durch die Intervalleinstelleinrichtung bewegt werden, an einer Position, die von der Kamera der Komponentenbestückungsvorrichtung abgebildet werden kann und wobei
die Steuervorrichtung des Komponentenbestückungsvorrichtung konfiguriert ist, um den Abstand zwischen dem Paar von Klemmelementen (12, 13) bezüglich der Position des Referenzmarkierungsabschnitts durch Erkennen der Referenzmarke aus einem von der Kamera aufgenommenen Bild des Referenzmarkierungsabschnitts (42, 44) zu überprüfen.

2. Die Komponentenbestückungsvorrichtung gemäß Anspruch 1, wobei
die Komponententransfervorrichtung (10) entfernbar in einen leeren Schlitz eines Zuführungsständers der Komponentenbestückungsvorrichtung eingesetzt ist und mit einem Verbinder (38) versehen ist, der mit einem Verbinder (37) des leeren Steckplatzes verbunden ist, welcher für die elektrische Energieversorgung und Kommunikation verwendet wird.

3. Die Komponentenbestückungsvorrichtung gemäß Anspruch 1 oder 2, wobei die Komponententransfervorrichtung (10) des weiteren ausgestattet ist mit
einer Intervalleinstelleinrichtung (31), die konfiguriert ist, um das Intervall zwischen dem Paar von Klemmelementen (12, 13) einzustellen.

4. Die Komponentenbestückungsvorrichtung gemäß einem der Ansprüche 1 bis 3, wobei
das Paar von Klemmelementen (12, 13) durch eine elastische Vorrichtung in der Klemmrichtung vorgespannt und in der Entspannungsrichtung elastisch bewegbar ist.

5. Die Komponentenbestückungsvorrichtung gemäß einem der Ansprüche 1 bis 4, wobei
die Komponententransfervorrichtung (10) so konfiguriert ist, dass sie an der Komponentenbestückungsvorrichtung so eingestellt werden kann, dass die Mittellinie der horizontalen Richtung des Paares von Klemmelementen (12, 13) senkrecht zur Transportrichtung der Leiterplatte in der Komponentenbestückungsvorrichtung liegt.

6. Die Komponentenbestückungsvorrichtung gemäß einem der Ansprüche 1 bis 5, wobei
eine Antriebsquelle, die zum Öffnen / Schließen des Paares von Klemmelementen (12, 13) konfiguriert ist, ein Luftzylinder (26) ist, und dem Luftzylinder (26) Luftdruck von der Komponentenbestückungsvorrichtung zugeführt wird.

7. Die Komponentenbestückungsvorrichtung gemäß einem der Ansprüche 1 bis 6, wobei
wenn mehrere Komponentenhalteabschnitte (16) an dem Montagekopf der Komponentenbestückungsvorrichtung vorgesehen sind, so dass mehrere Komponenten gehalten werden können, mehrere Paare von Klemmelementen (12, 13) vorgesehen sind, um den mehreren Komponentenhalteabschnitten (16) zu entsprechen.

8. Die Komponentenbestückungsvorrichtung gemäß einem der Ansprüche 1 bis 6, worauf die Komponententransfervorrichtung (10) und eine Komponentenversorgungseinrichtung, die zur Versorgung von Komponenten konfiguriert ist, eingesetzt sind, wobei
eine von der Komponentenversorgungseinrichtung gelieferte Komponente von dem Komponentenhalteabschnitt (16) des Montagekopfs aufgenommen und zwischen dem Paar von Klemmelementen (12, 13) der Komponententransfervorrichtung (10) festgeklemmt wird und dann zu dem Komponentenhalteabschnitt (16) des Montagekopfes transferiert wird, nachdem die Richtung der durch die Klemmelemente (12, 13) festgeklemmten Komponente um 90 Grad oder 180 Grad gedreht wurde, indem die Klemmelemente durch die Drehantriebsquelle um 90 Grad oder 180 Grad gedreht wurden .

## Revendications

1. Machine de montage de composants comprenant une tête de montage, une caméra, un dispositif de commande et un dispositif de transfert de composants (10) avec le dispositif de transfert de composants (10) comprenant:
une paire d'éléments de serrage (12, 13) qui se font face dans une direction horizontale et qui sont configurés pour serrer un composant en prenant en sandwich le composant de manière à transférer le composant vers une section de maintien de composants (16) de la tête de montage de la machine de montage de composants; et
une source d'entraînement en rotation configurée pour faire tourner les éléments de serrage (12, 13) autour d'une ligne centrale de la direction horizontale lorsqu'un composant est serré par les éléments de serrage (12, 13), dans lequel
le dispositif de transfert de composants (10) est configuré pour transférer le composant vers la section de maintien de composants (16) de la tête de montage de la machine de montage de composants dans un état dans lequel le composant est serré par les éléments de serrage (12, 13) et retourné à 90 degrés ou 180 degrés par la rotation des éléments de serrage (12, 13), rotation de 90 degrés ou 180 degrés effectuée par la source d'entraînement en rotation,
**caractérisé en ce que**
une section de repère de référence (42, 44) prévue sur un élément configuré pour se déplacer avec les éléments de serrage (12, 13) qui sont déplacés par les moyens de réglage d'intervalle, à une position susceptible d'être imagée par la caméra de la machine de montage de composants, et dans lequel
le dispositif de commande de la machine de montage de composants est configuré pour vérifier l'intervalle entre les deux éléments de serrage (12, 13) en se référant à la position de la section de repère de référence, en reconnaissant le repère de référence à partir d'une image de la section de repère de référence (42), 44) capturée par la caméra.

2. Machine de montage de composants selon la revendication 1, dans laquelle
le dispositif de transfert de composants (10) est installé de manière amovible dans un emplacement vide d'un support d'alimentation de la machine de montage de composants et est pourvu d'un connecteur (38) qui se connecte à un connecteur (37) de l'emplacement vide utilisé pour l'alimentation électrique et la communication.

3. Machine de montage de composants selon la revendication 1 ou la revendication 2, dans laquelle le dispositif de transfert de composants (10) est en outre pourvu un moyen de réglage d'intervalle (31) qui est configuré pour régler l'intervalle entre la paire d'éléments de serrage (12, 13).

4. Machine de montage de composants selon l'une quelconque des revendications 1 à 3, dans laquelle
les deux éléments de serrage (12, 13) sont sollicités dans le sens du serrage par un moyen élastique et sont mobiles de manière élastique dans le sens du desserrage.

5. Machine de montage de composants selon l'une quelconque des revendications 1 à 4, dans laquelle
le dispositif de transfert de composants (10) est configuré pour être placé sur la machine de montage de composants de sorte que la ligne médiane de la direction horizontale de la paire d'éléments de serrage (12, 13) est perpendiculaire au sens de transport de la carte de circuit imprimé dans la machine de montage de composants.

6. Machine de montage de composants selon l'une quelconque des revendications 1 à 5, dans laquelle
une source d'entraînement configurée pour ouvrir/fermer la paire d'éléments de serrage (12, 13) est un vérin pneumatique et une pression d'air est appliquée au vérin pneumatique (26) à partir de la machine de montage de composants.

7. Machine de montage de composants selon l'une quelconque des revendications 1 à 6, dans laquelle
lorsque plusieurs sections de maintien de composants (16) sont prévues sur la tête de montage de la machine de montage de composants de manière à pouvoir maintenir plusieurs composants,
de multiples paires d'éléments de serrage (12, 13) sont prévues pour correspondre aux multiples sections de maintien de composants (16).

8. Machine de montage de composants selon l'une quelconque des revendications 1 à 7, sur laquelle sont définis le dispositif de transfert de composants (10) et un dispositif d'alimentation en composants configuré pour acheminer les composants, dans laquelle
un composant acheminé par le dispositif d'alimentation en composants est saisi par la section de maintien de composants (16) de la tête de montage et serré entre la paire d'éléments de serrage (12, 13) du dispositif de transfert de composants (10), puis transféré vers la section de maintien de composants (16) de la tête de montage suivant la direction du composant serré par les éléments de serrage (12, 13) et retourné à 90 degrés ou 180 degrés par la rotation des éléments de serrage (12, 13), rotation de 90 degrés ou 180 degrés effectuée par la source d'entraînement en rotation.
